# EUROPÄISCHE PATENTANMELDUNG

(11) **EP 0 750 455 A1**
(43) Veröffentlichungstag der Anmeldung: **27.12.1996**
(21) Anmeldenummer: 96110039.3
(22) Anmeldetag: 21.06.1996
(51) Int. Cl.: H05K 13/00, B65G 13/00, B65G 39/02

(54) **Transporteinrichtung für die Behandlung plattenförmiger Gegenstände**

(30) Priorität: 22.06.1995 DE 19522734
(71) Anmelder: Gebr. Schmid GmbH & Co., D-72250 Freudenstadt (DE)
(72) Erfinder: Schmid, Dieter C., Dipl.-Ing., 72250 Freudenstadt-Dietersweiler (DE)
(74) Vertreter: Patentanwälte Ruff, Beier, Schöndorf und Mütschele

(57) **Zusammenfassung**

Eine Transporteinrichtung für die Behandlung plattenförmiger Gegenstände, insbesondere Leiterplatten, weist einen Transporteur mit mindestens einer Transportwelle (1) auf, der die Gegenstände längs einer Transportrichtung transportiert. Dabei sind der Transportwelle (1) an ihrem Außenumfang Auflageelemente (4) mit Auflagebereichen (5) für die plattenförmigen Gegenstände zugeordnet. Die Auflagebereiche (5) kontaktieren die plattenförmigen Gegenstände beim Transport längs Kontaktbereichen, die vorzugsweise streifenförmig ausgebildet sind. Erfindungsgemäß sind die erwähnten Kontaktbereiche in Transportrichtung unterbrochen.

## Beschreibung

Die Erfindung betrifft eine Transporteinrichtung für die Behandlung plattenförmiger Gegenstände gemäß dem Oberbegriff von Anspruch 1.

Bei der Behandlung plattenförmiger Gegenstände wie Leiterplatten stellen sich nicht nur beim Transport dieser Gegenstände von einer Behandlungsstation zur nächsten, sondern auch insbesondere beim Transport innerhalb einer Behandlungsstation besondere Probleme. So werden beispielsweise Leiterplatten, die auf oder zwischen Transportrollen horizontal geführt werden, häufig von oben und/oder unten mit flüssigen Lösungen behandelt beispielsweise besprüht oder bestrahlt. Dabei soll das Behandlungsmedium in vielen Fällen zügig von der behandelten Leiterplatte abfließen, damit diese nicht unerwünscht lange mit der Lösung, bzw. einer Ätzlösung in Kontakt bleibt. So soll bei einer Behandlung der Leiterplatte von oben eine Pfützenbildung weitgehend vermieden werden. Bei den bisher bekannten Ausführungen wird das Abfließen der Behandlungsflüssigkeit jedoch durch die verwendeten Transportmittel, insbesondere die auf den Transportwellen angeordneten Rollen, beeinträchtigt oder verhindert. Die meist sehr dicht angeordneten Transportmittel schirmen nämlich nicht nur einen beträchtlichen Teil der zu behandelnden Oberflächen der Leiterplatte nach oben bzw. unten ab, sondern behindern darüber hinaus ein Abfließen der Behandlungsflüssigkeit quer zur Transportrichtung. Die beschriebenen Nachteile zeigen sich sowohl bei einer Behandlung der Leiterplatten von oben als auch bei einer Behandlung von unten.

Die Erfindung stellt sich deshalb die Aufgabe, eine Transporteinrichtung der obengenannten Art derart zu verbessern, daß eine effektive Behandlung der Leiterplatten ermöglicht und die beschriebenen Nachteile vermieden werden.

Diese Aufgabe wird gelöst durch eine Transporteinrichtung mit den Merkmalen von Anspruch 1. Bevorzugte Ausführungsformen sind in den Unteransprüchen 2 bis 17 beschrieben. Der Wortlaut sämtlicher Ansprüche wird durch Bezugnahmne zum Inhalt der Beschreibung gemacht.

Die erfindungsgemäße Transporteinrichtung für die Behandlung plattenförmiger Gegenstände, insbesondere Leiterplatten, weist einen Transporteur mit mindestens einer Transportwelle auf, der die Gegenstände längs einer Transportrichtung transportiert. Dabei sind der Transportwelle an ihrem Außenumfang, je nachdem, ob sie mit der Leiterplatte von oben oder von unten zusammenwirken soll, Kontakt- bzw. Auflageelemente (im folgenden Auflageelemente genannt) mit Auflagebereichen für die plattenförmigen Gegenstände zugeordnet. Die Auflagebereiche kontaktieren die plattenförmigen Gegenstände beim Transport längs Kontaktbereichen, die vorzugsweise streifenförmig ausgebildet sind. Erfindungsgemäß sind die erwähnten Kontaktbereiche in Transportrichtung unterbrochen.

Die beschriebene Merkmalskombination hat insbesondere den Vorteil, daß beim Transport der Leiterplatten kein dauernder gleichzeitiger Kontakt zwischen den Auflageelementen mit ihren Auflagebereichen und den entsprechenden Flächen der Leiterplatte besteht. Damit steht jeder Teil der Leiterplattenfläche insgesamt länger für eine Behandlung beispielsweise mit der Behandlungsflüssigkeit zur Verfügung. Durch die geringere Abdeckung im Vergleich mit den bekannten Transporteinrichtungen ergibt sich insgesamt eine größere freie Behandlungsfläche, wenn die Leiterplatte mit der Behandlungsflüssigkeit bzw. -lösung besprüht oder bestrahlt wird. Darüber hinaus wird das (seitliche) Abströmen der Behandlungsflüssigkeit erleichtert, so daß sich insbesondere keine sogenannten "Längskanälen" bilden, in denen sich das Behandlungsmedium stauen könnte, wie dies beispielsweise bei den bereits erwähnten Transporteinrichtungen des Standes der Technik mit ihren (Voll-)Rollen der Fall ist. Mit anderen Worten wird durch die Erfindung insbesondere eine Abfließmöglichkeit für das Behandlungsmedium im Bereich der oberhalb und/oder unterhalb der Leiterplatte vorgesehenen Transportmittel geschaffen. Dieser zweite Vorteil der Erfindung zeigt sich insbesondere bei Ausführungsformen mit geringen seitlichen Abdeckungsflächen, wie sie im folgenden noch näher erläutert werden.

Vorzugsweise wird bei der Erfindung die maximale radiale Ausdehnung der Auflageelemente größer gewählt als der halbe Abstand der Transportwellen untereinander. Dies bedingt ein gegenseitiges Überlappen der Auflageelemente und ein "meinanderkämmen" beim Transport. Das genannte Merkmal kann entweder durch geeignete Ausgestaltung der Auflageelemente selbst oder durch eine versetzte Anordnung der Auflageelemente entlang der Transportwellen bzw. der Transportwellen verwirklicht werden. Die Bewegung der Transportwellen kann in diesen wie in allen übrigen Fällen beispielsweise über Zahnräder synchronisiert sein.

Die beschriebenen bevorzugten Ausführungsformen haben den zusätzlichen Vorteil, daß ein Umknicken oder ein Verhaken der Leiterplatten zwischen benachbarten Transportwellen zuverlässig verhindert wird. Dies ist deshalb von großer Bedeutung, da die zu transportierenden Leiterplatten immer dünner werden (zum Beispiel Folienmaterial bis hinunter zu 25 µm) und dementsprechend aufgrund ihrer Flexibilität sehr empfindlich sind.

Die Merkmalskombination der Erfindung läßt sich grundsätzlich durch verschiedene Ausgestaltungen der Transporteinrichtung erreichen. Bevorzugte Ausführungsformen liegen vor, wenn die an den Auflageelementen vorhandenen Auflagebereiche an einer wendelförmig ausgebildeten Außenfläche der Transportwelle gebildet sind. Bei diesen und anderen Ausführungsformen verlaufen die Auflagebereiche längs der Transportwelle schräg, so daß die Kontaktbereiche in Transportrichtung erfindungsgemäß unterbrochen sind und die erwähnten Vorteile erreicht werden. Vorzugsweise sind die Auflagebereiche wendelförmig oder schraubenförmig ausgebildet, wobei insbesondere eine gleiche Steigung zumindest über den Teil der Transportwelle vorhanden ist, über den die Wendel- oder Schraubenstruktur vorgesehen ist.

Bei den bisher beschriebenen und anderen Ausführungsformen kann die Transportwelle mindestens eine Wendel nach Art einer Schraubenfeder enthalten. Hier können eine oder mehrere Schraubenfedern über eine zu ihrer Stabilisierung dienende Transportwelle geführt sein. Dabei können die Schraubenfedern an ihren Enden konisch gewickelt und auf Druck zwischen Scheiben gehalten sein, die entweder paarweise an den Enden der Transportwelle oder bei Verwendung mehrerer Schraubenfedern paarweise an entsprechenden Stellen auf der Transportwelle vorgesehen sind. In Abweichung davon können die Schraubenfedern auch auf Zug gehalten sein und/oder es können längs der Transportwelle Stützen zur besseren Lagerung der Schraubenfeder(n) vorgesehen sein. Schließlich ist es denkbar, daß die Transportwelle von einer Schraubenfeder selbst oder von mehreren Schraubenfedern gebildet ist, so daß die Verwendung einer Stabilisierungswelle bzw. Stabilisierungsachse entfallen kann.

Bei allen erwähnten Ausführungsformen mit schräg verlaufenden bzw. wendelförmig ausgebildeten Auflagebereichen oder mit Wendeln nach Art einer Schraubenfeder können auch nur Teile der Transportwelle mit solchen Auflagebereichen oder Wendeln versehen sein. Entscheidend ist, ob insgesamt die erfindungsgemäße Merkmalskombination vorliegt.

Bei weiteren bevorzugten Ausgestaltungen mit der erfindungsgemäßen Merkmalskombination weisen die Auflageelemente über ihren Umfang unterbrochene Auflagebereiche auf. Bei solchen Ausführungsformen wird sowohl die gute Zugänglichkeit der Leiterplatte von oben und/oder unten für das Behandlungsmedium als auch das gute seitliche Abströmen des Behandlungsmediums in besonderem Maße gewährleistet. Insbesondere handelt es sich bei den Auflageelementen um Rollenabschnitte, die längs der Transportwelle in senkrecht zur Wellenachse definierten Ebenen angeordnet sind. Die Rollenabschnitte können grundsätzlich jede beliebige Form aufweisen, solange sie von einer (vollständigen) Rolle derart abweichen, daß sie nur einen Teil des Umfangs einer (vollständigen) Rolle abdecken. Zweckmäßig wird die Form solcher Rollenabschnitte so gewählt sein, daß durch die Auflageelemente eine möglichst große Durchtrittsfläche für das seitliche Abfließen des Behandlungsmediums zur Verfügung steht. Vorzugsweise handelt es sich bei den Auflageelementen um Rollenabschnitte in der Art von Kreisausschnitten oder Kreissektoren, die sich an die Transportwelle radial anschließen. Dementsprechend sind die Auflagebereiche für die Leiterplatten am Außenumfang der Kreisausschnitte gebildet. Die Unterbrechung der Kontaktbereiche in Transportrichtung beim Transport der Leiterplatten ist bei diesen Ausführungsformen durch den beispielsweise sektorartigen Aufbau der Auflageelemente gewährleistet.

In Weiterbildung sind die Auflageelemente, insbesondere die beschriebenen Kreisausschnitte, längs der Transportwelle gegeneinander versetzt angeordnet. Dadurch wird insbesondere erreicht, daß durch die Auflageelemente keine gleichartige seitliche Abschirmung längs der Transportwelle entsteht und somit das seitliche Abströmen gewährleistet ist.

Weiterhin können die Auflageelemente, insbesondere die beschriebenen Kreisausschnitte, entlang der Transportwelle in einer sich wiederholenden Abfolge angeordnet sein. Auf diese Weise wird gleichzeitig eine gleichmäßige Unterstützung der Leiterplatte durch die entsprechenden Auflagebereiche und ein gutes seitliches Abströmen durch möglichst geringe seitliche Abdeckungsflächen bewirkt.

Bei weiteren bevorzugten Ausführungsformen können entlang der Transportwelle benachbarte Auflageelemente bzgl. ihrer am Außenumfang gebildeten Auflagebereiche mit gegenseitiger Überlappung angeordnet sein. Dies bewirkt in erster Linie, daß beim Kontaktieren der Leiterplatte beim Transport durch die Auflageelemente einer Transportwelle eine dauernde Führung gewährleistet und somit ein Abknicken der empfindlichen Leiterplatte verhindert ist.

In Weiterbildung ist bevorzugt, wenn sich die Auflagebereiche von mindestens zwei entlang der Transportwelle benachbarten Kreisausschnitten zu einem Vollkreis ergänzen. Dieses Merkmal ist insbesondere in Verbindung mit einer sich gegenseitig überlappenden Anordnung benachbarter Auflageelemente von Vorteil.

Von den beschriebenen Ausführungsformen sind diejenigen bevorzugt, bei denen Rollenabschnitte, die längs der Transportwelle aufeinanderfolgen, um jeweils 120° gegeneinander versetzt sind. Bei solchen Ausführungsformen ergänzen sich insbesondere drei aufeinanderfolgende Kreisausschnitte zu einem Vollkreis. Insbesondere, aber nicht notwendig nur bei solchen Ausführungsformen, ist es bevorzugt, wenn ein Kreisausschnitt an seinem Außenumfang einen Winkel von mindestens 125°, insbesondere zwischen 140° und 150° abdeckt. Bei derart ausgestalteten Kreisausschnitten läßt sich in günstiger Weise eine Überlappung benachbarter Auflageelemente und damit eine zuverlässige Auflage der Leiterplatten erreichen.

Bei weiteren Ausführungsformen können die Auflageelemente aufeinanderfolgender Transportwellen gegeneinander versetzt angeordnet sein. Dadurch wird der Kontakt bzw. die Auflage der Leiterplatte bei der Übergabe von einer Transportwelle auf die nächste bei gleichzeitig möglichst geringer Abdeckung der Leiterplatte von oben und/oder unten einerseits und eine möglichst geringe seitliche Abdeckungsfläche zum seitlichen Abströmen des Behandlungsmittels andererseits gewährleistet.

Die Auflageelemente und dabei insbesondere die erwähnten Kreisausschnitte können an nabenförmigen Bauelementen angeordnet sein, die längs der Transportwelle aneinandergereiht sind. Dadurch lassen sich auf einfache Weise viele Auflageelemente bzw. Kreisausschnitte nebeneinander längs der Transportwelle anordnen. Üblicherweise sind dabei eine Vielzahl baugleicher nabenförmiger Bauelemente mit ihren Auflageelementen (Kreisausschnitten) auf die Transportwelle aufgeschoben, vorzugsweise ohne Abstand zueinander aneinandergereiht. Die Befestigung der nabenförmigen Bauelemente auf der Transportwelle kann in beliebiger Weise beispielsweise durch Verkleben oder Verklemmen erfolgen. Bei geeigneter Ausgestaltung kann die Transportwelle auch durch die nabenförmigen Bauelemente selbst gebildet sein, wenn diese im Verbund die erforderliche Stabilität für die Verwendung als Transportwelle besitzen.

Vorzugsweise sind an den nabenförmigen Bauelementen Eingriffsmittel vorgesehen, die die bei den bevorzugten Ausführungsformen geschilderte definierte Orientierung der Auflageelemente entlang der Transportwelle gewährleisten. Auf diese Weise ist es unnötig, die nabenförmigen Bauelemente entlang der Transportwelle entweder von Hand oder maschinell auszurichten und zu befestigen. Durch die Eingriffsmittel wird die richtige Orientierung bzw. Stellung der Auflageelemente bzw. Kreisausschnitte (automatisch) erreicht. Dabei kann es sich bei den Eingriffsmitteln insbesondere um Vorsprünge oder Ausnehmungen handeln, die an den miteinander zusammenwirkenden Stirnseiten der nabenförmigen Bauelemente vorgesehen sind. So können beispielsweise an einer Stirnseite dieser Bauelemente ein Vorsprung und an der anderen Stirnseite drei Ausnehmungen in passender 120°-Anordnung vorgesehen sein, so daß beim Aneinanderreihen mehrerer Bauelemente entlang der Transportwelle eine einfache Anordnung der Bauelemente in 120°-Versetzung mit sich wiederholender Abfolge durch Einfügen des Vorsprungs in die jeweilige Ausnehmung ermöglicht ist.

Als Material für die Transportwelle und für die Auflageelemente können grundsätzlich alle Materialien verwendet werden, die für die Behandlungsbedingungen der plattenförmigen Gegenstände, insbesondere der Leiterplatten, geeignet sind. Dementsprechend kann es sich um geeignete Metalle oder um entsprechend gegen die Behandlungsmedien beständige Kunststoffe handeln. Die Auflageelemente, insbesondere die Auflagebereiche, können vorzugsweise aus vergleichsweise weichem (beispielsweise gummiartigem) Material bestehen, um eine schonende Auflage empfindlicher Gegenstände (z.B. Leiterplatten) zu gewährleisten. Ggf. können die Auflagebereiche auch durch Borsten nach Art einer Bürstenoberfläche ausgebildet sein.

Die beschriebenen Merkmale und weitere Merkmale der Erfindung ergeben sich aus der nachfolgenden Beschreibung von bevorzugten Ausführungsformen in Verbindung mit den Unteransprüchen und den Zeichnungen. Hierbei können die einzelnen Merkmale jeweils für sich oder zu mehreren in Kombination miteinander verwirklicht sein.

In den Zeichnungen zeigen:
- Fig. 1: in Draufsicht die schematische Darstellung von zwei ausschnittsweise abgebildeten Transportwellen einer erfindungsgemäßen Transporteinrichtung,
- Fig. 2: die Anordnung gemäß Fig. 1 von der linken Stirnseite her betrachtet,
- Fig. 3: eine schematische Darstellung der Orientierung der drei auf einer Transportwelle gemäß Fig. 1 vorhandenen Auflageelemente,
- Fig. 4: in Draufsicht die schematische Darstellung von zwei ausschnittsweise abgebildeten Transportwellen einer weiteren erfindungsgemäßen Transporteinrichtung, und
- Fig. 5: in Draufsicht die schematische Darstellung von zwei ausschnittsweise abgebildeten Transportwellen einer weiteren erfindungsgemäßen Transporteinrichtung.

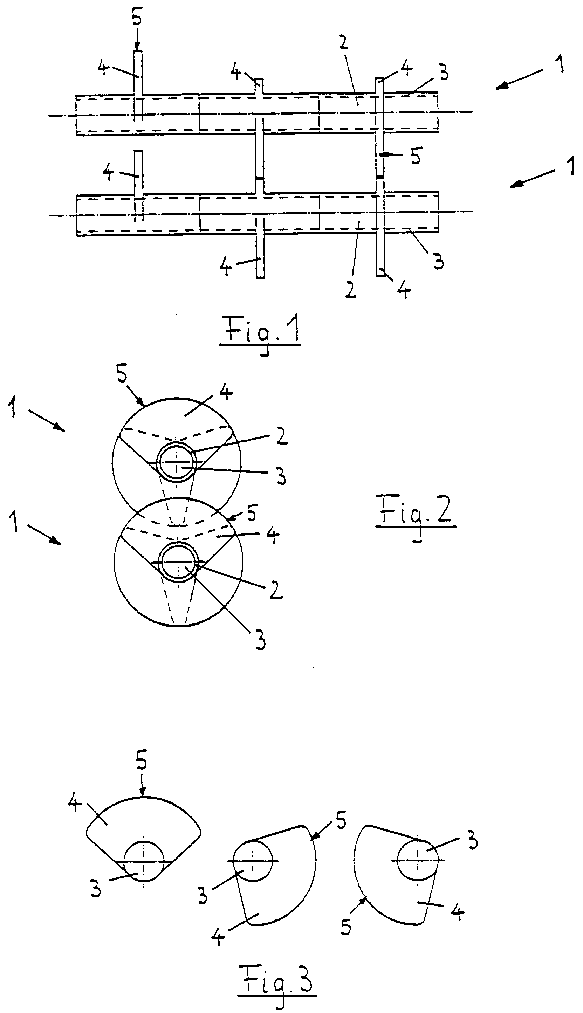

Fig. 1 zeigt von einer erfindungsgemäßen Transporteinrichtung zwei benachbarte Transportwellen 1, die beide ausschnittsweise in Draufsicht dargestellt sind. Beide Transportwellen 1 sind aus nabenförmigen Elementen 2 aufgebaut, die über eine in Fig. 1 gestrichelt angedeutete Welle 3 geführt und ohne gegenseitigen Abstand aneinandergereiht sind. Wie bereits beschrieben, können die nabenförmigen Elemente 2 mit der Welle 3 beispielsweise verklemmt oder durch Verkleben an dieser befestigt sein.

Jedes nabenförmige Element 2 einer Transportwelle 1 trägt ein Auflageelement 4 in Form eines als Kreisausschnitt (hier: Kreissektor) ausgebildeten Rollenabschnittes. Bei der in Fig. 1 dargestellten Ausführungsform sind die Kreisausschnitte 4 einer Transportwelle 1 durch entsprechende Anordnung der nabenförmigen Elemente 2 auf der Welle 3 um 120° gegeneinander versetzt. Die in Fig. 1 dargestellte Abfolge der Kreisausschnitte 4 wiederholt sich in den nicht dargestellten Teilen der Transportwellen 1, so daß eine regelmäßige Abfolge der Kreisausschnitte 4 entsteht, wobei der jeweils vierte Kreisausschnitt 4 die gleiche Orientierung besitzt wie ein jeweils erster Kreisausschnitt 4. Wie bereits beschrieben, kann die gegenseitige Orientierung der Kreisausschnitte 4 durch Eingriffsmittel wie Vorsprünge und/oder Ausnehmungen an den nabenförmigen Elementen 2 bewirkt werden. Derartige Eingriffsmittel sind in den Figuren nicht dargestellt.

Weiter zeigt Fig. 1, daß die maximale radiale Ausdehnung der Kreisausschnitte 4, gerechnet von der zentralen Achse der Welle 3, größer gewählt ist als der halbe Abstand der beiden Transportwellen 1 untereinander. Dadurch wird ein Zusammenwirken der beiden Transportwellen erreicht, bei dem ein Umknicken oder Einklemmen der empfindlichen Leiterplatten zuverlässig verhindert wird. Bei der in Fig. 1 dargestellten Ausführungsform ist es nicht erforderlich, die Kreisausschnitte 4 einer Transportwelle 1 gegenüber denen der benachbarten Transportwelle 1 in Längsrichtung der Transportwellen 1 versetzt anzuordnen, da aufgrund des sektorartigen Aufbaus der Auflageelemente 4 mit entsprechender Orientierung eine gegenseitige Berührung der Kreisausschnitte 4 benachbarter Transportwellen 1 ausgeschlossen ist.

Nach Fig. 2 sind die beiden Transportwellen 1 von Fig. 1 in seitlicher Draufsicht (untereinander) dargestellt. Dabei sind jeweils die auf der Welle 3 angeordneten nabenförmigen Elemente 2 zu erkennen. Dem Betrachter am nächsten ist der (gemäß Fig. 2 nach oben orientierte) Kreisausschnitt 4, der mit durchgezogener Linie dargestellt ist. Außerdem sind die beiden um 120° versetzten anderen Kreisausschnitte 4 durch gestrichelte Linien angedeutet. Dadurch ist erkennbar, wie die drei neben- bzw. gemäß Fig. 2 hintereinander angeordneten Kreisausschnitte 4 einer Transportwelle 1 sich zu einem Vollkreis ergänzen. Da jeder Kreisausschnitt 4 an seinem Außenumfang, das heißt mit seinen Auflagebereichen 5 einen Winkel von mindestens 125° überstreicht, ist durch diese "überlappende" Anordnung die Auflage bzw. Unterstützung einer Leiterplatte durch die Kreisausschnitte 4 einer Transportwelle 1 gewährleistet. Durch die geschilderte Wahl des Abstandes benachbarter Transportwellen 1 wird außerdem erreicht, daß die Leiterplatte von den Kreisausschnitten 4 einer benachbarten Transportwelle 1 zuverlässig "übernommen" wird.

Fig. 3 zeigt nochmals die um 120° versetzte Anordnung von drei entlang einer Transportwelle 1 aufeinanderfolgenden Kreisausschnitten 4, der Übersichtlichkeit halber in getrennter Darstellung. Dabei ist in Fig. 3 nur die Welle 3 ohne das nabenförmige Element 2 angedeutet.

Wie bereits hervorgehoben, ist die Ausführung gemäß den Figuren 1 bis 3 deshalb besonders bevorzugt, da hier nicht nur eine sehr gute Zugänglichkeit für die Leiterplatten von oben und/oder unten gewährleistet ist, sondern durch die geringe seitliche Abschirmung aufgrund des Aufbaus der Auflageelemente ein gutes seitliches Abströmen der aufgebrachten Behandlungsmedien erreicht wird.

Bei der in Fig. 4 dargestellten Ausführungsform sind zwei wendel- bzw. schraubenförmige (ggf. auch als schneckenartig bezeichenbare) Transportwellen 21 dargestellt, wobei eine Überlappung der beiden Transportwellen 21 dadurch vorgesehen ist, daß die maximale radiale Ausdehnung der Wendeln größer ist als der halbe Abstand der Transportwellen 21 untereinander. Bei dieser Ausführungsform sind das Auflageelement bzw. die Auflageelemente 22 durch die Wendeln der Transportwellen 21 gebildet. Die wendelförmig ausgebildete Außenfläche der Transportwellen 21 dient somit als Auflagebereiche 23 für die Leiterplatten.

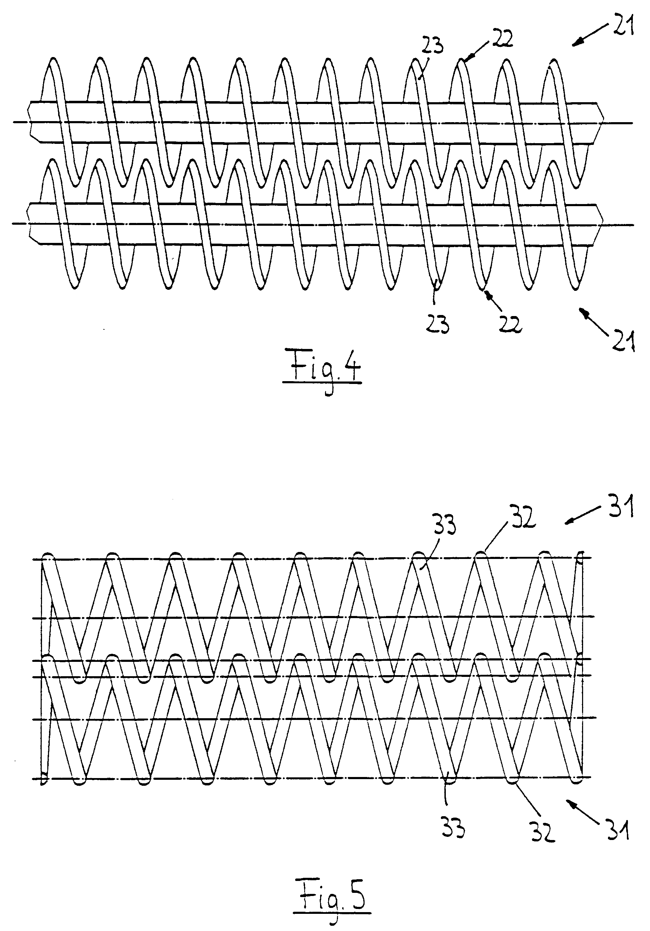

Fig. 5 zeigt zwei Transportwellen 31 einer erfindungsgemäßen Transporteinrichtung, die als Schraubenfedern ausgebildet sind. Auch bei dieser Ausführung sind die beiden Transportwellen 31 mit gegenseitiger Überlappung nebeneinander angeordnet, um die erwähnten zusätzlichen Vorteile zu erreichen. Dabei ist die Überlappung anhand der gestrichelten Linien in Fig. 5 erkennbar. Die Wendel der Schraubenfeder bildet dabei das Auflageelement bzw. die Auflageelemente 32 der Transportwellen 31 und die Auflage der Leiterplatten erfolgt auf die von der Außenfläche der Transportwellen 31 gebildeten Auflagebereiche 33.

Wie bereits beschrieben, können bei der Ausführung gemäß Fig. 5 die Schraubenfedern über eine zur Stabilisierung dienende Welle oder Achse gezogen sein. Auf die entsprechenden Stellen in der Beschreibung wird Bezug genommen.

Selbstverständlich ist die Erfindung nicht auf Ausführungen beschränkt, bei denen wie in den Figuren lediglich zwei Transportwellen vorgesehen sind. Vielmehr ist im Normalfall eine Vielzahl neben- bzw. hintereinander angeordneter Transportwellen in einem Transporteur vorhanden, wobei die Konstruktion der gesamten Transporteinrichtung in verschiedener, dem Fachmann geläufiger Weise erfolgen kann und die Transportwellen oberhalb und/oder unterhalb der zu transportierenden Leiterplatten angeordnet sein können.

## Patentansprüche

1. Transporteinrichtung für die Behandlung plattenförmiger Gegenstände, insbesondere Leiterplatten, mit einem Transporteur mit mindestens einer Transportwelle (1; 21; 31), der die plattenförmigen Gegenstände längs einer Transportrichtung transportiert, wobei der Transportwelle (1; 21; 31) an ihrem Außenumfang Auflageelemente (4; 22; 32) mit Auflagebereichen (5; 23; 33) für die plattenförmigen Gegenstände zugeordnet sind, und wobei die Auflagebereiche (5; 23; 33) beim Transport die plattenförmigen Gegenstände längs vorzugsweise streifenförmigen Kontaktbereichen kontaktieren, dadurch gekennzeichnet, daß die Kontaktbereiche in Transportrichtung unterbrochen sind.

2. Transporteinrichtung nach Anspruch 1, dadurch gekennzeichnet, daß die maximale radiale Ausdehnung der Auflageelemente (4; 22; 32) größer ist als der halbe Abstand von Transportwellen (1; 21; 31) untereinander.

3. Transporteinrichtung nach Anspruch 1 oder Anspruch 2, dadurch gekennzeichnet, daß die Auflagebereiche (23; 33) an einer mindestens teilweise wendelförmig ausgebildeten Außenfläche der Transportwelle (21; 31) gebildet sind.

4. Transporteinrichtung nach einem der vorhergehenden Ansprüche, dadurch gekennzeichnet, daß die Auflagebereiche (23) längs der Transportwelle (21) schräg verlaufend, insbesondere wendel- oder schraubenförmig ausgebildet sind.

5. Transporteinrichtung nach einem der vorhergehenden Ansprüche, dadurch gekennzeichnet, daß die Transportwelle (31) mindestens eine Wendel nach Art einer Schraubenfeder enthält.

6. Transporteinrichtung nach einem der vorhergehenden Ansprüche, dadurch gekennzeichnet, daß die Auflageelemente (4) über ihren Umfang unterbrochene Auflagebereiche (5) aufweisen.

7. Transporteinrichtung nach Anspruch 6, dadurch gekennzeichnet, daß die Auflageelemente (4) von längs der Transportwelle angeordneten Rollenabschnitten, insbesondere in der Art von Kreisausschnitten, die in senkrecht zur Wellenachse definierten Ebenen liegen, gebildet sind.

8. Transporteinrichtung nach Anspruch 6 oder 7, dadurch gekennzeichnet, daß die Auflageelemente (4) längs der Transportwelle gegeneinander versetzt angeordnet sind.

9. Transporteinrichtung nach einem der Ansprüche 6 bis 8, dadurch gekennzeichnet, daß die Auflageelemente (4) entlang der Transportwelle in einer sich wiederholenden Abfolge angeordnet sind.

10. Transporteinrichtung nach einem der Ansprüche 6 bis 9, dadurch gekennzeichnet, daß entlang der Transportwelle (1) benachbarte Auflageelemente (4) hinsichtlich ihres Umfanges mit gegenseitiger Überlappung angeordnet sind.

11. Transporteinrichtung nach einem der Ansprüche 7 bis 10, dadurch gekennzeichnet, daß die Auflagebereiche (5) von mindestens zwei entlang der Transportwelle (1) benachbarten Rollenabschnitten (4) sich zu einem Vollkreis ergänzen.

12. Transporteinrichtung nach einem der Ansprüche 7 bis 11, dadurch gekennzeichnet, daß längs der Transportwelle (1) aufeinanderfolgende Rollenabschnitte (4) um jeweils 120° gegeneinander versetzt sind, wobei insbesondere drei aufeinanderfolgende Rollenabschnitte (4) sich zu einem Vollkreis ergänzen.

13. Transporteinrichtung nach einem der Ansprüche 7 bis 12, dadurch gekennzeichnet, daß ein Rollenabschnitt (4) an seinem Außenumfang einen Winkel von mindestens 125°, insbesondere zwischen 140° und 150° abdeckt.

14. Transporteinrichtung nach einem der Ansprüche 6 bis 13, dadurch gekennzeichnet, daß die Auflageelemente aufeinanderfolgender Transportwellen gegeneinander versetzt angeordnet sind.

15. Transporteinrichtung nach einem der vorhergehenden Ansprüche, dadurch gekennzeichnet, daß die Auflageelemente (4) an nabenförmigen Bauelementen (2) angeordnet sind, die längs der Transportwelle aneinandergereiht sind.

16. Transporteinrichtung nach Anspruch 15, dadurch gekennzeichnet, daß an den nabenförmigen Bauelementen Eingriffsmittel für die Anordnung der Auflageelemente mit definierter Orientierung entlang der Transportwelle vorgesehen sind.

17. Transporteinrichtung nach Anspruch 16, dadurch gekennzeichnet, daß es sich bei den Eingriffsmitteln um Vorsprünge und/oder Ausnehmungen handelt.
